# FASCICULE DE BREVET EUROPEEN

(11) **EP 3 496 168 B1**
(45) Date de publication et mention de la délivrance du brevet: **10.06.2020**
(21) Numéro de dépôt: 18208416.0
(22) Date de dépôt: 26.11.2018
(51) Int. Cl.: H01L 45/00

(54) **PROCÉDÉ DE FABRICATION D'UN POINT MEMOIRE DE TYPE OXRAM POUR LIMITER LES DISPERSIONS DES CARACTÉRISTIQUES ET LE MEMOIRE CORRESPONDANT**
VERFAHREN ZUR HERSTELLUNG EINES PUNKTSPEICHERS VOM OXRAM-TYP ZUR VERRINGERUNG DER STREUUNG DER EIGENSCHAFTEN UND DER ENTSPRECHENDE SPEICHER
METHOD OF FABRICATING A POINT MEMORY OF THE OXRAM TYPE TO LIMIT THE VARIATIONS OF CHARACTERISTICS AND CORRESPONDING MEMORY

(30) Priorité: 05.12.2017 FR 1761627
(43) Date de publication de la demande: 12.06.2019
(73) Titulaire: Commissariat à l'Énergie Atomique et aux Énergies Alternatives, 75015 Paris (FR)
(72) Inventeur: BARLAS, Marios, 38400 ST MARTIN D'HÈRES (FR); BLAISE, Philippe, 38000 GRENOBLE (FR); GRENOUILLET, Laurent, 38640 CLAIX (FR); TRAORE, Boubacar, 38100 GRENOBLE (FR)
(74) Mandataire: Guérin, Jean-Philippe

(56) Documents cités:
- US-A1- 2015 318 472
- US-A1- 2017 244 028

## Description

L'invention concerne les mémoires RRAM, et en particulier les procédés de fabrication de telles mémoires.

Afin de surmonter les limites en termes de miniaturisation, consommation électrique et complexité de fabrication des technologies mémoires non-volatiles à grille flottante, l'industrie des semi-conducteurs développe différentes technologies alternatives. Parmi les technologies de mémoires non volatiles alternatives en cours de développement, les mémoires de type RRAM présentent un intérêt technique certain.

Les mémoires de type RRAM sont basées sur la formation et la rupture réversible d'un filament conducteur : un matériau diélectrique, qui est normalement isolant, peut être forcé à être conducteur à travers un filament ou un chemin de conduction après l'application d'une tension suffisamment élevée. Une fois que le filament est formé, il peut être réinitialisé ou programmé par une tension appliquée de façon appropriée.

Dans le cas particulier des mémoires OxRAM, le filament conducteur est réalisé à partir de lacunes d'oxygène dans un matériau isolant à base d'oxyde métallique. Les mémoires OXRAM bénéficient d'une très bonne stabilité thermique, permettant en théorie de conserver l'information de façon fiable pendant plusieurs années à haute température, avec une durée de vie d'un très grand nombre de cycles de programmation/déprogrammation et/ou lecture.

Un oxyde usuel utilisé comme matériau isolant dans une mémoire est le HfO₂. A l'échelle macroscopique, la zone de l'oxyde dans laquelle le filament est formé présente soit un état isolant, soit un état conducteur à l'état programmé, soit un état semi-conducteur à l'état réinitialisé.

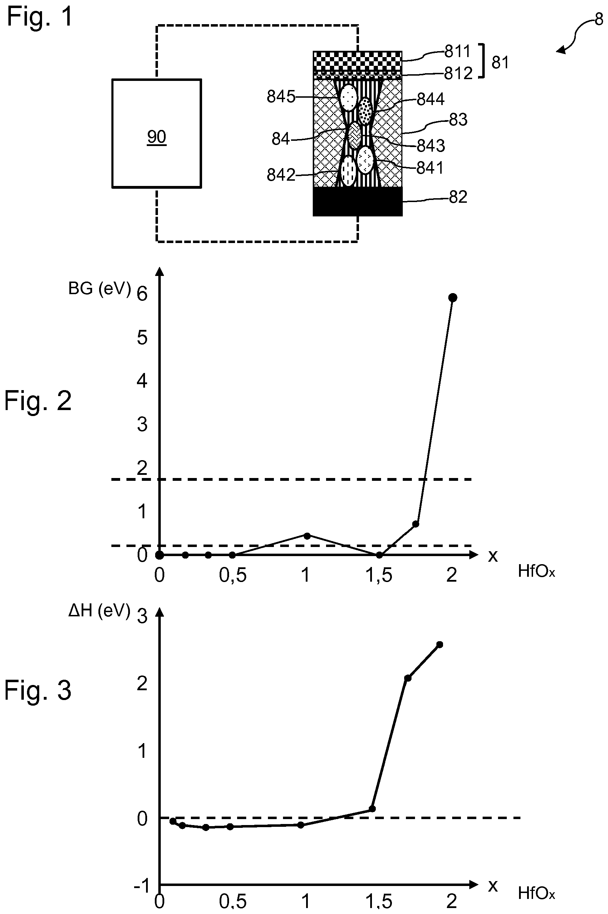

La figure 1 est une vue en coupe schématique d'un exemple de point mémoire 8 de type OxRAM. Le point mémoire 8 de type OxRAM comprend une électrode supérieure 81 métallique, une électrode inférieure métallique 82, et un diélectrique 83 interposé entre l'électrode supérieure 81 et l'électrode inférieure 82.

L'électrode supérieure 81 est ici avantageusement décomposée en un élément supérieur conducteur 811, et un élément inférieur 812 de récupération des lacunes d'oxygène. L'élément supérieur 811 est typiquement en TiN, l'élément inférieur 812 étant par exemple en Ti. L'élément inférieur 812 présente typiquement une épaisseur comprise entre 3 et 15 nm.

Le diélectrique 83 est rendu sélectivement conducteur par application d'une différence de potentiel appropriée entre l'électrode supérieure 81 et l'électrode inférieure 82 par un circuit de commande 90. Le diélectrique 83 est destiné à laisser migrer des lacunes d'oxygène de cette couche 83 vers les électrodes 81 ou 82 pour former le filament conducteur 84 à l'état programmé, et vice-versa. A l'état programmé, un filament conducteur 84 est formé dans le diélectrique 83. Cet état programmé est conservé même en l'absence d'alimentation du point mémoire 8.

Par l'application d'une autre différence de potentiel par l'intermédiaire du circuit de commande 90, on peut déprogrammer le point mémoire 8 et rompre le filament 84. Le diélectrique 83 a alors un état à forte résistance, dit HRS pour High Résistance State en langue anglaise.

En appliquant par la suite une différence de potentiel de lecture entre les électrodes 81 et 82, le circuit de commande 90 peut mesurer le courant traversant le point mémoire 8 pour déterminer si celui-ci est à l'état programmé ou réinitialisé.

En pratique, le diélectrique 83 comporte de multiples domaines présentant des compositions différentes dans la zone du filament 84. Ainsi, sur la figure, on a illustré schématiquement des zones 841 à 845 présentant différentes phases sous-stoechimétriques de HfOₓ dans le HfO₂.

On a constaté que ces zones différentes 841 à 845 ont des valeurs de bande interdite différentes pour des phases d'oxyde semi-conductrices (0 < BG < 2. La figure 2 montre l'énergie de la bande interdite de différentes phases sous-stœchiométriques de HfOx dans le HfO₂ : Il existe deux gammes des phases sous-stœchiométriques avec un comportement métallique et un comportement semi-conducteur. Pour les phases semi-conductrices, des petites variations de stœchiométrie induisent des variations de la bande interdite. La figure 3 montre la stabilité thermodynamique des phases sous-stœchiométriques: Pour x < 1.5, toute la gamme des phases semi-conductrices sont stables, et peuvent se former pendant le changement de l'état mémoire de l'état LRS à l'état HRS. De telles variations de la bande interdite BG induisent de fortes dispersions dans le comportement électrique des différents points mémoire, ainsi que dans le comportement électrique d'un même point mémoire pour différents cycles de programmation/réinitialisation. Par conséquence, l'état HRS présente une forte dispersion des propriétés électriques qui est un point particulièrement limitant pour l'industrialisation de la technologie OxRAM. Des procédés et des mémoires OxRAM connus sont décrits par US 2017 / 0244028 A1 et par US 2015 / 0318472 A1.

L'invention vise à résoudre un ou plusieurs de ces inconvénients. L'invention porte ainsi sur un procédé de fabrication d'un point mémoire de type OxRAM, tel que défini dans la revendication 1 annexée.

L'invention porte également sur les variantes des revendications dépendantes. L'homme du métier comprendra que chacune des caractéristiques des variantes des revendications dépendantes ou de la description peut être combinée indépendamment aux caractéristiques d'une revendication indépendante sans pour autant constituer une généralisation intermédiaire.

L'invention porte également sur un point mémoire de type OxRAM, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe schématique d'un point mémoire selon l'état de la technique, muni d'un circuit de programmation/lecture ;
- la figure 2 est un diagramme illustrant l'énergie de la bande interdite de différentes phases sous stœchiométriques d'une zone de filament ménagée dans du HfO₂ ;
- la figure 3 illustre les différences de stabilité thermodynamique des différentes phases sous stœchiométriques de HfOₓ dans du HfO₂ ;
- la figure 4 est une vue en coupe schématique d'une étape d'un procédé de fabrication selon un exemple d'un premier mode de réalisation de l'invention ;
- la figure 5 est un diagramme illustrant l'énergie de la bande interdite de différentes phases sous stœchiométriques d'une zone de filament ménagée dans un isolant réalisé selon l'invention ;
- la figure 6 est un diagramme illustrant l'énergie de la bande interdite de différentes phases sous stœchiométriques, en fonction de la proportion de Titane incluse ;
- la figure 7 est un diagramme comparatif de la stabilité thermodynamique d'un alliage sous stœchiométriques de Hf_{1-y}Ti_{y}O_{1,5} par rapport à du Hf_{1-y}Ti_{y}O₂, en fonction de la valeur de y ;
- la figure 8 est un diagramme illustrant la proportion de titane dans une zone de filament en fonction de la profondeur, pour différentes valeurs d'énergie d'implantation ;
- la figure 9 est une vue en coupe d'une étape d'un procédé de fabrication selon une variante du premier mode de réalisation de l'invention ;
- la figure 10 est une vue en coupe schématique d'un exemple de structure d'une zone de filament obtenu par l'intermédiaire du procédé illustré à la figure 9 ;
- la figure 11 est une vue en coupe d'une étape d'un procédé de fabrication selon un exemple d'un deuxième mode de réalisation de l'invention ;
- la figure 12 est un diagramme illustrant la concentration de différents composants dans une couche de Hf_{1-y}Ti_{y}O₂, en fonction de l'énergie d'implantation utilisée pour l'implantation ionique ;
- la figure 13 est un diagramme illustrant la concentration de Titane en fonction de la profondeur dans un point mémoire, pour différentes énergies d'implantation.

L'invention propose un procédé de fabrication d'un point mémoire de type OxRam. Dans ce procédé, on propose d'implanter du Ti dans une couche inférieure, de HfO₂. Cette implantation est réalisée par une implantation ionique d'un matériau choisi parmi le Xe, le Kr ou le Ar, dans une couche supérieure, incluant plus de 50 % en masse de Ti. L'implantation ionique dans cette couche supérieure induit dans celle-ci une collision avec effet de recul, conduisant à une implantation du Ti dans la couche inférieure de HfO₂.

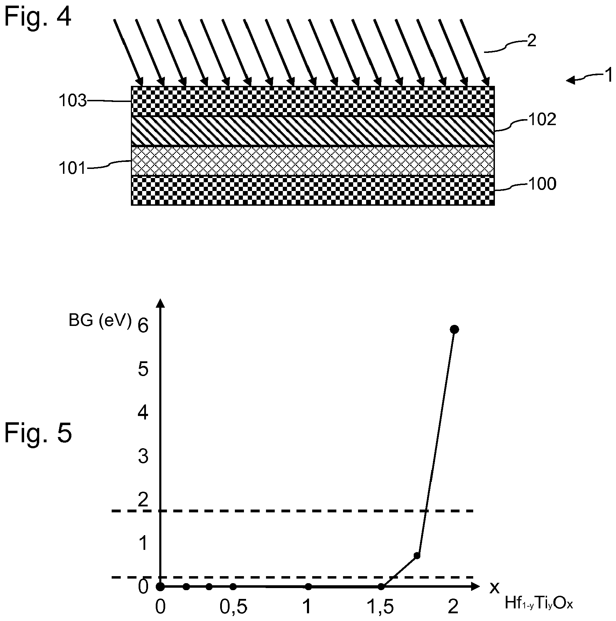

La figure 4 est une vue en coupe schématique d'un empilement 1 durant une étape d'un procédé de fabrication d'un point mémoire de type OxRam, selon un exemple d'un premier mode de réalisation de l'invention.

L'empilement 1 comprend ici la superposition d'une couche 100, d'une couche 101, d'une couche 102 et d'une couche 103. La couche 100 est par exemple une couche destinée à former une électrode inférieure du point mémoire en cours de fabrication. La couche 100 peut par exemple être en tout matériau conducteur approprié, par exemple en TiN dans cet exemple. La couche 103 est par exemple une couche destinée à former une électrode supérieure du point mémoire en cours de fabrication. La couche 103 est donc en contact électrique avec une face de la couche 101, par l'intermédiaire de la couche 102. La couche 103 inclut avantageusement du Ti. La couche 103 est par exemple réalisée dans le même matériau que la couche 100 et est par exemple formée en TiN dans cet exemple.

La couche 101 est disposée sur la couche 100. La couche 101 est en HfO₂. La couche 102 est disposée sur la couche 101. La couche 102 inclut un matériau du Ti à plus de 30 % en fraction molaire, de préférence plus de 50% en fraction molaire. La couche 102 est ici en Ti. La couche 103 est disposée sur la couche 102. Pour une couche 102 en Ti, la couche 103 permet avantageusement d'éviter son oxydation. Une couche 103 en TiN permet d'une part d'éviter l'oxydation de la couche 102 en Ti, d'autre part de former une électrode pour le point mémoire en cours de fabrication, et par ailleurs de fournir du Ti pour une implantation par collision avec effet de recul dans la couche 101. La couche 100 est en contact électrique avec une face de la couche 101.

Le procédé met ici en œuvre une étape d'implantation ionique d'un matériau 2, parmi le Xe, le Kr ou le Ar. L'implantation ionique est ici réalisée dans les couches 103 et 102. Du fait de l'implantation ionique dans les couches 102 et 103, la collision avec effet de recul sur du Ti des couches 102 et 103 induit une implantation de ce Ti dans la couche 101. On peut ainsi former des zones de création de filament dans la couche 101, avec une composition de type Hf_{1-y}Ti_{y}O₂.

Le diagramme de la figure 5 montre l'énergie de la bande interdite de différentes phases sous stœchiométriques de Hf_{1-y}Ti_{y}Oₓ dans le Hf_{1-y}Ti_{y}O₂ de la couche 101 obtenue, avec une valeur y de 0,2. Ce diagramme montre que la présence de ces multiples phases sous stœchiométriques avec un alliage de Ti permet d'homogénéiser les énergies de bande interdite de ces multiples phases sous stœchiométriques, pour x≤1,5. Une seule phase correspond à un état réinitialisé, pour x=1,75. Par conséquent, des points mémoires utilisant un tel diélectrique présentent des dispersions de comportement fortement réduites. Ainsi, la discrimination entre un état programmé et un état réinitialisé peut être effectuée de façon relativement aisée. Ainsi, les différences de potentiel pour commuter entre les états programmé et réinitialisé du point mémoire peuvent être sensiblement réduites, sans altérer la lecture du point mémoire.

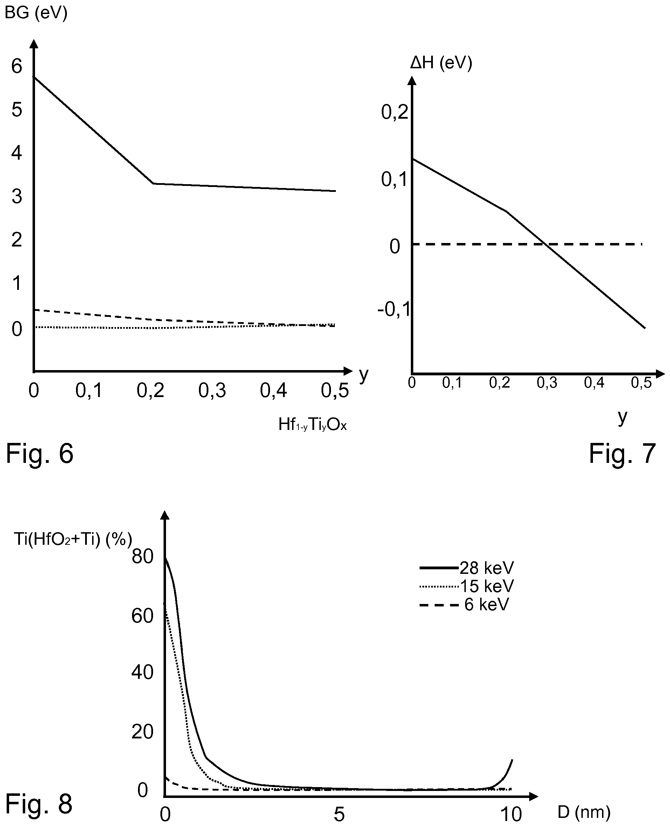

La figure 6 est un diagramme illustrant l'énergie de la bande interdite de différentes phases sous stœchiométriques, en fonction de la proportion de Titane incluse dans du Hf_{1-y}Ti_{y}O₂ et du Hf_{1-y}Ti_{y}O_{1.5}. Ce diagramme montre que la phase Hf_{1-y}Ti_{y}O₂ conserve une énergie de bande interdite importante jusqu'à une valeur de y =0,5, ce qui garantit de conserver de bonnes propriétés d'isolation pour la phase Hf_{1-y}Ti_{y}O₂ et de permettre la formation de phases semi-conductrices. On constate également que les phases Hf_{1-y}Ti_{y}Oₓ pour x=1 ou x=1,5 conservent une énergie de bande interdite relativement faible et stable, quelle que soit la valeur de y.

La figure 7 est un diagramme comparatif de la stabilité thermodynamique d'un alliage sous stœchiométriques de Hf_{1-y}Ti_{y}O_{1,5} par rapport à du Hf_{1-y}Ti_{y}O₂, en fonction de la valeur de y. On constate que le Hf_{1-y}Ti_{y}O₂ est plus stable que le Hf_{1-y}Ti_{y}O_{1.5}, jusqu'à une valeur de y de 0,3 approximativement. On utilisera ainsi avantageusement une valeur y≤0,3 pour générer moins de Hf_{1-y}Ti_{y}O et de Hf_{1-y}Ti_{y}O_{1,5}, qui sont plus stables et formés en plus grande proportion au-delà de cette valeur.

On déduit de ces diagrammes qu'une valeur de y comprise entre 0,05 et 0,3 s'avère avantageuse, pour conserver à la fois une réduction des dispersions, une augmentation de la stabilité thermodynamique, et de bonnes propriétés isolantes de la majeure partie de la couche 101. De préférence, la valeur de y est comprise entre 0,1 et 0,25.

L'implantation ionique du Xe, du Kr ou du Ar est mise en œuvre avec une inclinaison comprise entre 5 et 30° par rapport à la normale à la couche 102, et de préférence entre 7 et 25°. Une telle inclinaison pour l'implantation ionique permet de faire baisser la proportion de Ti dans la profondeur de la couche 101.

La figure 8 est un diagramme illustrant la proportion de Ti dans la couche 101 en fonction de la profondeur dans cette couche 101, pour différentes valeurs d'énergie d'implantation. L'implantation ionique est ici réalisée avec une inclinaison de 7°, et une dose d'implantation ionique de Xe de 10¹⁵ cm⁻². Dans cet exemple, la couche 100 était en TiN, la couche 101 présentait une épaisseur de 10nm, la couche 102 présentait une épaisseur de 5nm de Ti, et la couche 103 présentait une épaisseur de 5nm de TiN. Le diagramme illustre que la concentration en Ti décroît fortement dans la profondeur de la couche 101, ce qui permet de délimiter la zone de la couche 101 incluant une concentration significative en Ti.

Par ailleurs, on a constaté qu'une concentration significative de Ti était implantée dans la couche 101, à partir d'une énergie d'implantation au moins égale à 10keV. L'énergie d'implantation est avantageusement au plus de 40 keV.

L'implantation dans la couche 101 par collision avec effet recul avec du Xe, du Kr ou du Ar permet d'obtenir des concentrations du matériau implanté relativement élevées, à partir d'une dose d'implantation ionique relativement réduite, en particulier par rapport à un procédé d'implantation ionique directe dans la couche 101. La durée du processus d'implantation ionique peut ainsi être relativement réduite, ce qui raccourcit la durée du processus de fabrication du point mémoire.

Avantageusement, l'implantation ionique est réalisée avec du Xe, qui s'avère électriquement inerte et suffisamment lourd pour maximiser l'effet de recul, ce qui est intéressant pour ne pas perturber les propriétés électriques du point mémoire par son implantation parasite dans la couche 101. Avantageusement, la dose d'implantation ionique de Xe est comprise entre 2*10¹⁴ cm⁻² et 4*10¹⁵ cm⁻², de préférence entre 5*10¹⁴ cm⁻² et 2*10¹⁵ cm⁻².

Avantageusement, la couche 103 présente une épaisseur comprise entre 3 et 12 nm, de préférence égale à 5nm. De préférence, la couche 102 présente une épaisseur comprise entre 3 et 12 nm, de préférence égale à 5nm. De préférence, la somme des épaisseurs des couches 102 et 103 est comprise entre 6 et 15 nm. De préférence, la couche 101 présente une épaisseur comprise entre 3 et 20 nm, de préférence égale à 10nm.

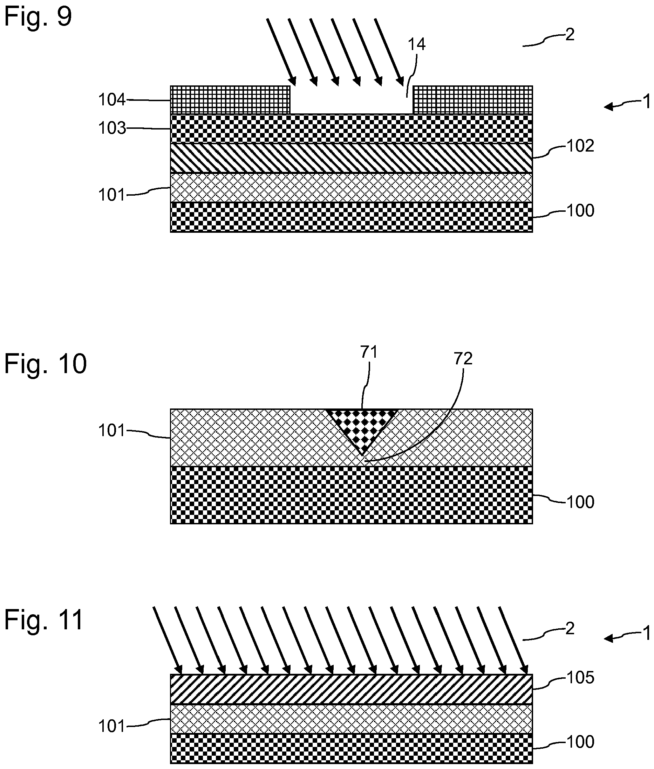

Avantageusement, l'implantation ionique est mise en œuvre à travers une ouverture 14 d'un masque dur 104, comme illustré dans la vue en coupe de la figure 9, d'une variante du premier mode de réalisation.

La figure 10 est une vue en coupe schématique d'un exemple de structure de la couche 101, obtenue par l'intermédiaire de la variante illustrée à la figure 9. L'utilisation de l'ouverture 14 du masque, combinée à la décroissance de la concentration en Ti dans l'épaisseur de la couche 101, permet d'obtenir une implantation de Ti présentant une section 71 de forme sensiblement triangulaire. Une telle section 71 de forme triangulaire permet de limiter le volume de la zone de filament pouvant potentiellement présenter des défauts.

La section 71 de la couche 101 présente une proportion de Ti donnée. La section 71 est ici entourée par une section 72 de la couche 101 présentant une proportion de Ti bien plus faible, voire nulle. En particulier, la section 72 peut présenter une proportion de Ti au moins deux fois inférieure à celle de la section 71.

La zone 72 forme ici une séparation entre la zone 71 et l'interface entre les couches 100 et 101. Avantageusement, l'épaisseur de cette séparation est au moins égale à 1nm, et de préférence au plus égale à 2nm (Pour garantir une conduction à travers le point mémoire à l'état LRS avec une différence de potentiel faible). La présence d'une telle séparation permet de réduire la dimension de la zone 71 pouvant présenter des défauts, et permet d'obtenir un effet de pointe pour le filament formé, avec une localisation très précise du filament formé et donc une limitation de dispersions à la commutation.

La zone 71 peut être formée en utilisant une implantation ionique avec un angle compris entre 20 et 25° par rapport à la normale à la couche 101. Un tel angle permet de favoriser l'effet de pointe.

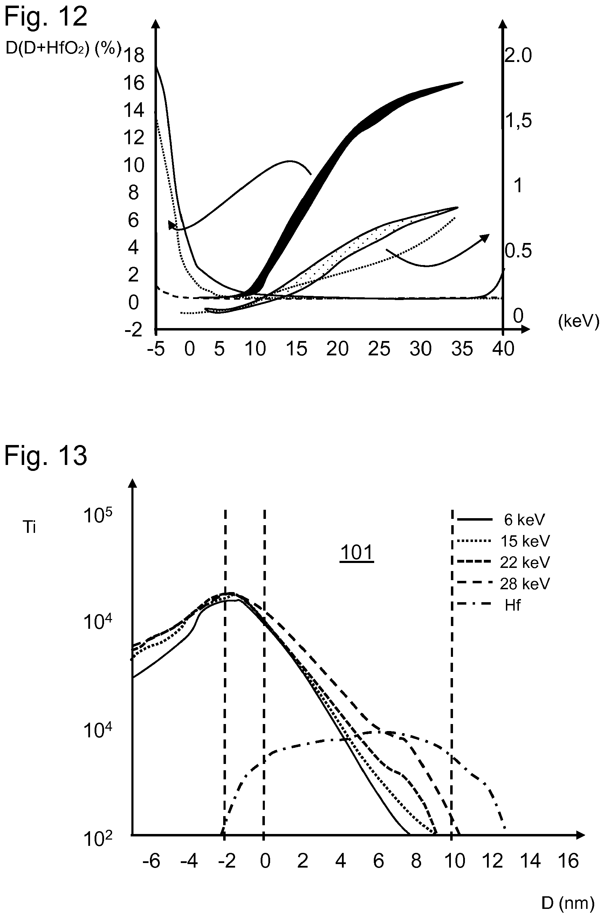

Le diagramme de la figure 12 illustre l'influence de l'énergie d'implantation de l'implantation ionique, sur la concentration de différents composants dans la couche 101. La surface noircie correspond à la concentration en Ti, la surface en pointillés correspond à la concentration en Xe, et la ligne en trait discontinu correspond à la concentration en N. On peut constater de façon générale que les concentrations respectives en N et en Xe restent relativement faibles quelle que soit l'énergie d'implantation, et typiquement inférieures à 1%. On peut notamment en déduire que la superposition des couches 102 et 103 permet de limiter la quantité de Xe implantée dans la couche 101. On peut également en déduire que la présence de la couche 103 n'induit pas une concentration excessive en N dans la couche 101. Une concentration limitée en N dans la couche 101 suite à l'implantation ionique permet d'éviter de perturber la commutation du point mémoire. On peut également constater qu'une énergie d'implantation élevée permettait d'implanter une quantité relativement importante de Ti dans la couche 101. Un point mémoire caractéristique d'un procédé de fabrication selon l'invention présente une couche 101 présentant une concentration en Xe typiquement comprise entre 0,1 et 0,9%.

Selon une variante, on peut réaliser un recuit par étapes, dans une plage allant de 300 à 450°C : cela permet de faire diffuser le Ti dans la couche 101 et d'optimiser son profil d'implantation. Un tel recuit est compatible avec les budgets thermiques utilisés dans les couches de métallisation.

La figure 11 est une vue en coupe schématique d'un empilement 1 durant une étape d'un procédé de fabrication d'un point mémoire de type OxRam, selon un exemple d'un deuxième mode de réalisation de l'invention.

L'empilement 1 comprend ici la superposition d'une couche 100 et d'une couche 101, pouvant présenter les dimensions et compositions détaillées dans le premier mode de réalisation. La couche 100 est ici aussi en contact électrique avec une face de la couche 101.

L'empilement 1 comprend en outre une couche de TiO₂ 105. La couche 105 est disposée sur la couche 101. La couche 105 présente une épaisseur comprise entre 3 et 12 nm, de préférence égale à 5nm. Dans ce mode de réalisation, la couche de TiO₂ 105 peut être obtenue en réalisant préalablement un dépôt de Ti sur la couche 101, puis en laissant cette couche de Ti s'oxyder pour former la couche de TiO₂ 105.

Le procédé met ici aussi en œuvre une étape d'implantation ionique d'un matériau 2, parmi le Xe, le Kr ou le Ar. L'implantation ionique est ici réalisée dans la couche 105. Du fait de l'implantation ionique dans la couche 105, la collision avec effet de recul sur du Ti de la couche 105 induit une implantation de ce Ti dans la couche 101. On peut ainsi former des zones de création de filament dans la couche 101, avec une composition de type Hf_{1-y}Ti_{y}O₂. L'implantation ionique peut être réalisée avec de mêmes paramètres d'inclinaison, de dose, ou d'énergie d'implantation.

L'implantation ionique est réalisée avec une couche 105 découverte et directement en contact avec la couche 101. Ainsi, pour une énergie d'implantation donnée, la proportion de Ti pouvant être implantée dans la couche 101 par collision avec effet de recul peut être accrue. Par ailleurs, du fait de la densité d'oxygène dans la couche 105, l'implantation par collision avec effet de rebond favorise la formation de la phase Hf_{1-y}Ti_{y}O₂ dans la couche 101. On peut ainsi mieux contrôler la commutation entre l'état programmé et l'état réinitialisé du point mémoire.

Le procédé de fabrication peut comprendre une étape ultérieure de dépôt d'une couche de TiN sur la couche 105, en vue de former une autre électrode du point mémoire.

Le diagramme de la figure 13 représente la concentration en Ti en fonction de la profondeur, dans un empilement 1, pour différentes énergies d'implantation de Xe. La profondeur D = 0 correspond à l'interface entre une couche 102 telle que décrite précédemment et une couche 101 d'une épaisseur de 10nm. La courbe en trait plein correspond à une énergie d'implantation de Xe 6keV, la couche en pointillés correspond à une énergie d'implantation de Xe de 15keV, la couche en trait discontinu correspond à une énergie d'implantation de Xe de 22keV, une autre couche en trait discontinu correspond à une énergie d'implantation de Xe de 28keV, et la courbe en tiret-point correspond à la trace du Hf.

On peut constater d'une part que la décroissance de la proportion de Ti dans la couche 101 décroit assez linéairement, quelle que soit l'énergie d'implantation. Une telle implantation peut donc permettre assez aisément d'obtenir un profil d'implantation de Ti présentant une section 71 de forme sensiblement triangulaire, comme illustré à la figure 10. Par ailleurs, on peut constater que l'énergie d'implantation permet d'influencer assez précisément la concentration de Ti à l'interface entre les couches 101 et 102, en fonction de l'énergie d'implantation de Xe. On constate en outre que l'énergie d'implantation permet de contrôler assez précisément la profondeur d'implantation de Ti, et donc de contrôler assez précisément la dimension d'une épaisseur d'une zone 72 entre la section 71 et l'interface entre les couches 100 et 101.

## Revendications

1. Procédé de fabrication d'un point mémoire de type OxRAM, comprenant les étapes de :
- fournir un empilement (1) comprenant une superposition de :
- une première couche (102) incluant un premier matériau en Ti à plus de 30% en fraction molaire ;
- une deuxième couche (101) en HfO₂ disposée sous la première couche ;
- par une implantation ionique d'un deuxième matériau (2) choisi parmi le Xe, le Kr ou le Ar dans la première couche (102), cette implantation étant réalisée avec une inclinaison comprise entre 5 et 30° par rapport à la normale à la première couche (102) et avec une énergie d'implantation comprise entre 10 et 40 keV, réaliser une implantation du premier matériau dans la deuxième couche (101) par collision avec effet de recul dans la première couche (102).

2. Procédé de fabrication selon la revendication 1, dans lequel ledit premier matériau est du Ti, et dans lequel ladite implantation du premier matériau dans la deuxième couche (101) est réalisée dans une première zone (71), de sorte que la composition dans ladite première zone soit du Hf_{1-y}Ti_{y}O₂, avec y compris entre 0,05 et 0,3.

3. Procédé de fabrication selon la revendication 2, dans lequel ladite deuxième couche (101) comprend une deuxième zone (72) entourant la première zone (71), deuxième zone dans laquelle la proportion en Ti est au moins deux fois inférieure à celle de la première zone.

4. Procédé de fabrication selon la revendication 3, dans lequel ladite deuxième couche (101) est disposée sur une troisième couche (100) en un matériau différent de celui de la deuxième couche (101), ladite deuxième zone (72) séparant la première zone (71) d'une interface entre la deuxième couche (101) et la troisième couche (100).

5. Procédé de fabrication selon la revendication 4, dans lequel l'épaisseur de la deuxième zone (72) séparant la première zone (71) d'une interface entre la deuxième couche (101) et la troisième couche (100) est au moins égale à 1 nm.

6. Procédé de fabrication selon l'une quelconque des revendications 2 à 5, dans lequel ledit empilement fourni (1) inclut une quatrième couche (103), disposée sur la première couche (102), la quatrième couche (103) étant en TiN, la première couche (101) étant en Ti.

7. Procédé de fabrication selon l'une quelconque des revendications 2 à 5, dans lequel ladite première couche (105) est en TiO₂.

8. Procédé de fabrication selon l'une quelconque des revendications précédentes, dans lequel ledit deuxième matériau est du Xe et dans lequel ladite dose d'implantation ionique est comprise entre 2*10¹⁴ cm⁻² et 4*10¹⁵ cm⁻².

9. Procédé de fabrication selon l'une quelconque des revendications précédentes, dans lequel ledit empilement fourni (1) comprend une première couche (102) présentant une épaisseur comprise entre 3 et 12 nm, et une deuxième couche (101) présentant une épaisseur comprise entre 7 et 20 nm.

10. Procédé de fabrication selon l'une quelconque des revendications précédentes, comprenant la formation de première et de deuxième électrodes (81,82) en contact électrique respectivement avec une face supérieure et avec une face inférieure de ladite deuxième couche (101).

11. Procédé de fabrication selon la revendication 10, comprenant une étape de connexion d'un circuit de programmation/réinitialisation aux première et deuxième électrodes, ledit circuit de programmation/réinitialisation étant configuré pour appliquer sélectivement une différence de potentiel entre les première et deuxième électrodes de façon à créer/rompre un filament conducteur à travers la deuxième couche (101).

12. Procédé de fabrication selon l'une quelconque des revendications précédentes, dans lequel ledit empilement fourni (1) inclut un masque dur (104) comportant une ouverture (14), ladite implantation ionique étant réalisée à travers ladite ouverture (14).

13. Point mémoire de type OxRAM, incluant un empilement (1) comprenant une superposition de :
- une première couche (102) incluant un premier matériau en Ti à plus de 30% en fraction molaire ;
- une deuxième couche (101) incluant majoritairement du HfO₂, disposée sous la première couche et présentant une implantation de Ti ;
**Caractérisé en ce que** la deuxième couche inclut du Xe avec une concentration molaire comprise entre 0,1 et 0,9%.

## Patentansprüche

1. Verfahren zur Herstellung eines Punktspeichers vom Typ OxRAM, welches die Schritte umfasst:
- Bereitstellen eines Stapels (1), der eine Überlagerung umfasst von:
- einer ersten Schicht (102), die ein erstes Ti-Material mit einem Stoffmengenanteil von über 30 % enthält;
- einer zweiten Schicht (101) aus HfO₂, die unter der ersten Schicht angeordnet ist;
- durch eine Ionenimplantation eines zweiten Materials (2), das aus Xe, Kr und Ar gewählt ist, in die erste Schicht (102), wobei diese Implantation mit einer Neigung zwischen 5 und 30° in Bezug auf die Normale zur ersten Schicht (102) und mit einer Implantationsenergie zwischen 10 und 40 keV durchgeführt wird, Durchführen einer Implantation des ersten Materials in die zweite Schicht (101) durch Kollision mit Rückstoßeffekt in der ersten Schicht (102).

2. Verfahren zur Herstellung nach Anspruch 1, wobei das erste Material Ti ist und wobei die Implantation des ersten Materials in die zweite Schicht (101) in einem ersten Bereich (71) so durchgeführt wird, dass die Zusammensetzung in dem ersten Bereich Hf_{1-y}Ti_{y}O₂ ist, mit y zwischen 0,05 und 0,3.

3. Verfahren zur Herstellung nach Anspruch 2, wobei die zweite Schicht (101) einen zweiten Bereich (72) umfasst, der den ersten Bereich (71) umgibt, wobei in diesem zweiten Bereich der Anteil an Ti mindestens um den Faktor zwei niedriger als derjenige des ersten Bereichs ist.

4. Verfahren zur Herstellung nach Anspruch 3, wobei die zweite Schicht (101) auf einer dritten Schicht (100) aus einem Material, das von demjenigen der zweiten Schicht (101) verschieden ist, angeordnet ist, wobei der zweite Bereich (72) den ersten Bereich (71) von einer Grenzfläche zwischen der zweiten Schicht (101) und der dritten Schicht (100) trennt.

5. Verfahren zur Herstellung nach Anspruch 4, wobei die Dicke des zweiten Bereichs (72), der den ersten Bereich (71) von einer Grenzfläche zwischen der zweiten Schicht (101) und der dritten Schicht (100) trennt, mindestens 1 nm beträgt.

6. Verfahren zur Herstellung nach einem der Ansprüche 2 bis 5, wobei der bereitgestellte Stapel (1) eine vierte Schicht (103) enthält, die auf der ersten Schicht (102) angeordnet ist, wobei die vierte Schicht (103) aus TiN besteht und die erste Schicht (101) aus Ti besteht.

7. Verfahren zur Herstellung nach einem der Ansprüche 2 bis 5, wobei die erste Schicht (105) aus TiO₂ besteht.

8. Verfahren zur Herstellung nach einem der vorhergehenden Ansprüche, wobei das zweite Material Xe ist und wobei die Ionenimplantationsdosis zwischen 2*10¹⁴ cm⁻² und 4*10¹⁵ cm⁻² liegt.

9. Verfahren zur Herstellung nach einem der vorhergehenden Ansprüche, wobei der bereitgestellte Stapel (1) eine erste Schicht (102), die eine Dicke zwischen 3 und 12 nm aufweist, und eine zweite Schicht (101), die eine Dicke zwischen 7 und 20 nm aufweist, umfasst.

10. Verfahren zur Herstellung nach einem der vorhergehenden Ansprüche, welches die Ausbildung einer ersten und einer zweiten Elektrode (81, 82), die mit einer Oberseite bzw. mit einer Unterseite der zweiten Schicht (101) in elektrisches Kontakt stehen, umfasst.

11. Verfahren zur Herstellung nach Anspruch 10, welches einen Schritt des Anschlusses einer Programmier-/Reset-Schaltung an die erste und die zweite Elektrode umfasst, wobei die Programmier-/Reset-Schaltung dafür ausgelegt ist, selektiv eine Potentialdifferenz zwischen der ersten und der zweiten Elektrode anzulegen, um ein leitfähiges Filament durch die zweite Schicht (101) hindurch zu erzeugen/zu unterbrechen.

12. Verfahren zur Herstellung nach einem der vorhergehenden Ansprüche, wobei der bereitgestellte Stapel (1) eine Hartmaske (104) enthält, die eine Öffnung (14) aufweist, wobei die Ionenimplantation durch die Öffnung (14) hindurch durchgeführt wird.

13. Punktspeichers vom Typ OxRAM, welcher einen Stapel (1) enthält, der eine Überlagerung umfasst von:
- einer ersten Schicht (102), die ein erstes Ti-Material mit einem Stoffmengenanteil von über 30 % enthält;
- einer zweiten Schicht (101), die überwiegend HfO₂ enthält, unter der ersten Schicht angeordnet ist und eine Implantation von Ti aufweist;
**dadurch gekennzeichnet, dass** die zweite Schicht Xe mit einer Stoffmengenkonzentration zwischen 0,1 und 0,9 % enthält.

## Claims

1. Method for fabricating an OxRAM memory cell, comprising the steps of:
- providing a stack (1) comprising a superposition of:
- a first layer (102) including a first material containing a molar fraction of Ti of more than 30%;
- a second layer (101) made of HfO₂ placed under the first layer;
- by ion implantation of a second material (2), chosen from Xe, Kr and Ar, into the first layer (102), this implantation being carried out with an inclination comprised between 5 and 30° with respect to the normal to the first layer (102) and with an implantation energy comprised between 10 and 40 keV, achieving an implantation of the first material into the second layer (101) via collision with recoil in the first layer (102).

2. Fabrication method according to Claim 1, wherein said first material is Ti, and wherein said implantation of the first material into the second layer (101) is performed in a first region (71), so that the composition in said first region is Hf_{1-y}Ti_{y}O₂ with y comprised between 0.05 and 0.3.

3. Fabrication method according to Claim 2, wherein said second layer (101) comprises a second region (72) encircling the first region (71), in which second region the proportion of Ti is at least two times lower than the proportion of Ti in the first region.

4. Fabrication method according to Claim 3, wherein said second layer (101) is placed on a third layer (100) made of a material different from the material of the second layer (101), said second region (72) separating the first region (71) from an interface between the second layer (101) and the third layer (100).

5. Fabrication method according to Claim 4, wherein the thickness of the second region (72) separating the first region (71) from an interface between the second layer (101) and the third layer (100) is at least equal to 1 nm.

6. Fabrication method according to any one of Claims 2 to 5, wherein said provided stack (1) includes a fourth layer (103) placed on the first layer (102), the fourth layer (103) being made of TiN and the first layer (101) being made of Ti.

7. Fabrication method according to any one of Claims 2 to 5, wherein said first layer (105) is made of TiO₂.

8. Fabrication method according to any one of the preceding claims, wherein said second material is Xe and wherein said ion implantation dose is comprised between 2×10¹⁴ cm⁻² and 4×10¹⁵ cm⁻².

9. Fabrication method according to any one of the preceding claims, wherein said provided stack (1) comprises a first layer (102) having a thickness comprised between 3 and 12 nm, and a second layer (101) having a thickness comprised between 7 and 20 nm.

10. Fabrication method according to any one of the preceding claims, comprising forming first and second electrodes (81, 82) in electrical contact with an upper face and with a lower face of said second layer (101), respectively.

11. Fabrication method according to Claim 10, comprising a step of connecting a program/reset circuit to the first and second electrodes, said program/reset circuit being configured to selectively apply a potential difference across the first and second electrodes so as to create/break a conductive filament through the second layer (101).

12. Fabrication method according to any one of the preceding claims, wherein said provided stack (1) includes a hard mask (104) comprising an aperture (14), said ion implantation being carried out through said aperture (14).

13. OxRAM memory cell, including a stack (1) comprising a superposition of:
- a first layer (102) including a first material containing a molar fraction of Ti of more than 30%;
- a second layer (101) mainly including HfO₂, placed under the first layer and comprising an implantation of Ti;
**characterized in that** the second layer includes a molar concentration of Xe comprised between 0.1 and 0.9%.
